Europäisches Patentamt

European Patent Office

Office européen des brevets

(19)

(11) Veröffentlichungsnummer: **0 293 645**

**A1**

(12) **EUROPÄISCHE PATENTANMELDUNG**

(21) Anmeldenummer: 88107515.4

(22) Anmeldetag: 10.05.88

(51) Int. Cl.4: **C23C 14/08** , **C23C 14/24** , **C23C 14/34** , **C23C 16/40** , **H01L 21/285** , //G03G5/082

(30) Priorität: 04.06.87 DE 3718762

(43) Veröffentlichungstag der Anmeldung:
07.12.88 Patentblatt 88/49

(84) Benannte Vertragsstaaten:
AT BE CH DE FR GB IT LI LU

(71) Anmelder: **Siemens Aktiengesellschaft Berlin und München**
**Wittelsbacherplatz 2**
**D-8000 München 2(DE)**

(72) Erfinder: **Müller, Werner**
**Zeppelinstrasse 5**
**D-8025 Unterhaching(DE)**

(54) **Verfahren zur Herstellung von transparenten, leitfähigen Indium-Zinn-Oxidschichten, insbesondere für Bildsensorzeilen auf der Basis von amorphem Silizium.**

(57) Während der Beschichtung der durch Aufdampfen oder Aufstäuben der Ausgangsmetalle oder deren Oxide auf die amorphe wasserstoffhaltige, auf einem unbeheizten Substrat befindlichen Siliziumschicht erzeugten Indium-Zinn-Oxidschicht wird vorübergehend durch Abschalten der Sauerstoffzufuhr der Sauerstoffpartialdruck im Rezipienten reduziert. Die Elektrodenstrukturen werden nach der Beschichtung geätzt; die Temperung erfolgt im Sauerstoffstrom oder Luft bei kleiner 250°C. Dadurch werden Schichten erhalten, welche eine Transparenz für sichtbares Licht von 90 Prozent und gleichzeitig einen elektrischen Flächenwiderstand von 200 Ohm pro square aufweisen. Das Verfahren wird verwendet bei der Herstellung von transparenten Elektroden für Bildsensorelemente.

EP 0 293 645 A1

## Verfahren zur Herstellung von transparenten, leitfähigen Indium-Zinn-Oxidschichten, insbesondere für Bildsensorzeilen auf der Basis von amorphem Silizium.

Die Erfindung betrifft ein Verfahren zur Herstellung von transparenten, leitfähigen Indium-Zinn-Oxidschichten (ITO), wie sie insbesondere als Elektroden für Bildsensorzeilen auf der Basis von amorphem, wasserstoffhaltigen Silizium (a-Si:H) verwendet werden, durch Aufdampfen oder Aufstäuben der Ausgangsmetalle oder deren Oxide auf die amorphe, wasserstoffhaltige Siliziumschicht und nachträgliches Tempern in Sauerstoffatmosphäre.

Der Erfindung liegt die Aufgabe zugrunde, ein Verfahren zur Herstellung transparenter, leitfähiger Elektrodenschichten aus Indium-Zinn-Oxid (ITO) unter den eingeschränkten Bedingungen niedriger Temperaturbelastung, wie sie bei Bildsensoren aus amorphem Silizium (a-Si:H) vorliegen, anzugeben.

Es ist bekannt, daß die Deckelektrode von Bildsensorzeilen eine hohe Transparenz für sichtbares Licht von mindestens 85 % und gleichzeitig einen kleinen elektrischen Flächenwiderstand von weniger als 300 Ohm/square aufweisen muß. Derartige Spezifikationen können nur durch ITO-Schichten erreicht werden, die entweder bei Temperaturen über 200° C niedergeschlagen worden sind oder bei Temperaturen über 440° C nachgetempert werden (siehe Bericht von I. Hamberg, C. G. Granqvist, J. Appl. Phys. 60 (11) (1986) R 123 bis R 129).

Für die Erwärmung des Indium-Zinn-Oxids bei der Herstellung von Bildwandlern müssen folgende Punkte beim Schichtniederschlag und beim Tempern berücksichtigt werden:

1. Um die ITO-Schicht nach ihrem Niederschlag photolithographisch strukturieren zu können, darf das niedergeschlagene Material keine höhere Temperatur als ca. 150° C annehmen. Eine höhere Behandlungstemperatur würde die chemische Löslichkeit des ITO so herabsetzen, daß ein rückstandsfreies Strukturätzen nicht mehr möglich ist. Bei der einzigen alternativen Methode zur Strukturierung, der sogenannten Abhebetechnik, muß das Substrat während der Beschichtung mit strukturiertem Photolack bedeckt sein, der nach Überschreitung einer Temperatur von ca. 100° C nicht mehr weiterverarbeitet, das heißt durch organische Lösungsmittel nicht mehr abgehoben werden kann.

2. Das unter dem ITO liegende photoleitende amorphe wasserstoffhaltige Silizium verliert oberhalb von 300° C den für seine halbleitenden Eigenschaften entscheidenden Gehalt an Wasserstoff. Das Nachtempern bei 440° C, welches im Fall kalt niedergeschlagener und fertig strukturierter ITO-Schichten zu den geforderten Spezifikationen führen würde (siehe Bericht von Raviendraid et. al., physica status solidi (a) 88 (1985) K 83 bis K 86 und Bericht von Hamberg) ist daher hier nicht anwendbar. Außerdem stellt neben den genannten Einschränkungen eine Aufheizung und die anschließende Abkühlung von Substraten im Zuge eines Fabrikationsprozesses ein erhebliches Erschwernis hinsichtlich der Kosten und der Durchlaßzeiten dar.

Das Problem konnte bis jetzt noch nicht befriedigend gelöst werden. Indem die üblichen ITO-Herstellverfahren hinsichtlich der Probenerwärmung auf die genannten Einschränkungen abgeändert wurden, erhält man Spezifikationen des ITO, die deutlich schlechter sind. Dadurch ist die Leistungsfähigkeit der Bildsensoren spürbar verringert.

Ein Verfahren, welches sich auch mit diesem Problem befaßt, ist beispielsweise aus der europäischen Patentanmeldung 0 214 095 zu entnehmen. Bei diesem Verfahren wird zur Verbesserung der Widerstandswerte (300 Ohm pro square) bei gleichbleibender Transparenz (90 Prozent) die Temperung bei maximal 200° C in zwei Schritten durchgeführt, wobei zunächst zur Erreichung der Trans parenz in Sauerstoffatmosphäre und danach für die Einstellung des Schichtwiderstandes in einer plasmaaktivierten Formiergasatmosphäre getempert wird.

Die Erfindung löst das Problem auf eine andere Weise und ist durch ein Verfahren der eingangs genannten Art dadurch gekennzeichnet, daß

a) ein ungeheiztes Substrat für die Beschichtung verwendet wird,

b) während der Beschichtung vorübergehend der Sauerstoffpartialdruck im Rezipienten reduziert wird,

c) nach der Beschichtung die Elektrodenstrukturen geätzt werden und

d) die Temperung in Sauerstoffstrom oder Luft bei Temperaturen kleiner 250° C durchgeführt wird. Dabei liegt es im Rahmen der Erfindung, daß zu Beginn der Beschichtung der Sauerstoffpartialdruck im Bereich von $10^{-4}$ bis $10^{-2}$ mbar eingestellt wird und nach ca. einem Drittel der gewünschten Schichtdicke durch Abschalten der Sauerstoffzufuhr auf kleiner $1 \times 10^{-5}$ mbar abgesenkt wird. Nach einem weiteren Drittel der gewünschten Schichtdicke wird durch erneutes Zuschalten von Sauerstoff wieder der ursprüngliche Sauerstoffpartialdruck eingestellt.

Weitere Ausgestaltungen der Erfindung ergeben sich aus den Unteransprüchen.

Durch das Verfahren nach der Lehre der Erfindung können ITO-Schichten hergestellt werden, welche einen elektrischen Flächenwiderstand von 200 Ohm pro square (entspricht einem spezifischen Widerstand von $20 \times 10^{-4}$ Ohm cm) und eine Transparenz für sichtbares Licht von 90 Prozent zeigen.

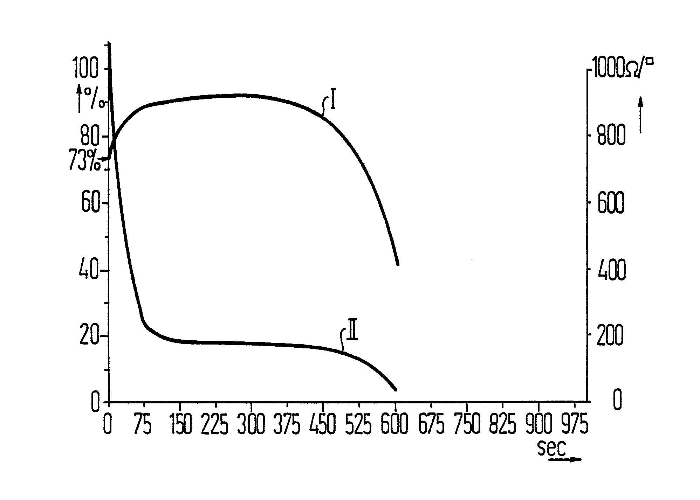

Weitere Einzelheiten der Erfindung werden nachfolgend anhand eines Ausführungsbeispiels beschrieben. Die Figur zeigt in einem Diagramm die Abhängigkeit der Transparenz (Prozent) und des Schichtwiderstandes (Ohm pro square) von der Ausfallzeit (Sekunden) das heißt der Sauerstoffunterbrechung. Die Kurve I gibt die Transparenzwerte, die Kurve II die Schichtwiderstandswerte wieder. Wie aus dem Kurvenverlauf zu entnehmen ist, werden bei einer Abschaltzeit des Sauerstoffs im Bereich von 150 bis 345 Sekunden die optimalsten Werte für Transparenz und Schichtwiderstand erhalten.

Ausführungsbeispiel:

In einem reaktiven Aufdampfprozeß wird oxidisches Ausgangsmaterial ($In_2 O_3$ mit 16 Gewichtsprozent $SnO_2$) mit einer Elektronenstrahlkanone auf ein ungeheiztes Substrat (amorphe wassserstoffhaltige Siliziumschicht) gedampft. Der Sauerstoffpartialdruck im Rezipient wird zu Beginn der Bedampfung auf $8 \times 10^{-4}$ mbar eingestellt. Durch Regelung der Leistung der Elektronenstrahlkanone wird eine Aufdampfrate von 0,1 nm/s eingehalten. Nach dem Niederschlag von 30 nm auf dem Substrat wird bei fortgesetzter Bedampfung die Sauerstoffzufuhr abgeschaltet, so daß der Sauerstoffdruck auf kleiner $1 \times 10^{-5}$ mbar absinkt. Nach einer Abschaltzeit von 300 Sekunden wird der Sauerstoffdruck wieder auf den ursprünglichen Wert von $8 \times 10^{-4}$ mbar hochgeregelt und die Bedampfung bis zum Erreichen einer Schichtdicke von ca. 100 nm fortgesetzt. Die Schichten werden dem Rezipienten entnommen und in einem Ofen unter Sauerstoffströmung bei 200°C eine Stunde lang getempert.

Mikroskopische Untersuchungen an Querschliffen erfindungsgemäß hergestellter Schichten aus ITO zeigen eine deutlich dichtere Struktur als Schichten, die ohne Unterbrechung der Sauerstoffzufuhr hergestellt worden sind.

Die chemische Ätzbarkeit dieser Schichten zur photolithographischen Strukturierung nach der Aufdampfung und vor der Temperung ist sehr gut; es wurden keine Ätzrückstände beobachtet.

Nach dem Sputterverfahren hergestellte ITO-Schichten zeigen den gleichen vorteilhaften Effekt. Das Gleiche gilt auch für ITO-Schichten, bei deren Herstellung metallische Ausgangsmaterialien verwendet worden sind.

## Ansprüche

1. Verfahren zur Herstellung von transparenten, leitfähigen Indium-Zinn-Oxid-Schichten (ITO), wie sie insbesondere als Elektroden für Bildsensorzeilen auf der Basis von amorphem, wasserstoffhaltigen Silizium (a-Si:H) verwendet werden, durch Aufdampfen oder Aufstäuben der Ausgangsmetalle oder deren Oxide auf die amorphe, wasserstoffhaltige Siliziumschicht und nachträgliches Tempern in Sauerstoffatmosphäre, **dadurch gekennzeichnet, daß**

a) ein ungeheiztes Substrat für die Beschichtung verwendet wird,

b) während der Beschichtung vorübergehend der Sauerstoffpartialdruck im Rezipienten reduziert wird,

c) nach der Beschichtung die Elektrodenstrukturen geätzt werden und

d) die Temperung in Sauerstoffstrom oder Luft bei Temperaturen kleiner 250°C durchgeführt wird.

2. Verfahren nach Anspruch 1, **dadurch gekenn-zeichnet**, daß zu Beginn der Beschichtung der Sauerstoffpartialdruck im Bereich von $10^{-4}$ bis $10^{-2}$ mbar eingestellt wird.

3. Verfahren nach Anspruch 1 oder 2, **dadurch ge-kennzeichnet**, daß zu Beginn der Beschichtung ein Sauerstoffpartialdruck im Rezipienten von $8 \times 10^{-4}$ mbar eingestellt wird, welcher nach ca. einem Drittel der gewünschten Schichtdicke durch Abschaltung der Sauerstoffzufuhr auf kleiner $1 \times 10^{-5}$ mbar abgesenkt wird und nach einem weiteren Drittel der gewünschten Schichtdicke durch erneutes Zuschalten von Sauerstoff wieder auf den Ausgangswert eingeregelt wird.

4. Verfahren nach einem der Ansprüche 1 bis 3, **dadurch gekennzeichnet**, daß die Unterbrechung der Sauerstoffzufuhr im Bereich zwischen 75 und 450 Sekunden variiert wird.

5. Verfahren nach einem der Ansprüche 1 bis 4, **dadurch gekennzeichnet**, daß zur Herstellung einer 100 nm dicken Indium-Zinn-Oxid-Schicht durch Elektronenstrahlbedampfung von oxidischen Ausgangsmaterial bei einer Abscheiderate von 0,1 nm/sec nach Erreichen einer Schichtdicke von ca. 30 nm die Sauerstoffzufuhr bei fortgesetzter Bedampfung für ca. 300 Sekunden unterbrochen wird.

6. Verfahren nach einem der Ansprüche 1 bis 5, **dadurch gekennzeichnet**, daß die Schichten in einem Ofen bei 200°C unter Sauerstoffströmung ca. 1 Stunde lang getempert werden.

## EINSCHLÄGIGE DOKUMENTE

EP 88107515.4

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US - A - 4 361 114 (H.GUREV)<br>* Spalte 3, Zeilen 35-39; Ansprüche *<br>-- | 1 | C 23 C 14/08<br>C 23 C 14/24<br>C 23 C 14/34<br>C 23 C 16/40<br>H 01 L 21/285<br>//G 03 G 5/082 |
| A | PATENT ABSTRACTS OF JAPAN, unexamined applications, C Field, Vol. 10, No. 136, 20. Mai 1986<br>THE PATENT OFFICE JAPANESE GOVERNMENT<br>Seite 13 C 347<br>* Kokai-no. 60-258 460 (SUMITOMO KAGAKU KOGYO K.K.) *<br>-- | 1,2 | |
| A | PATENT ABSTRACTS OF JAPAN, unexamined applications, C Sektion, Vol. 2, No. 136, 11. November 1978<br>THE PATENT OFFICE JAPANESE GOVERNMENT<br>Seite 2989 C 78<br>* Kokai-no. 53-102 881 (TEIJIN K.K.) *<br>---- | 1 | |

**RECHERCHIERTE SACHGEBIETE (Int. Cl.4)**

C 23 C

H 01 L

G 03 G

Der vorliegende Recherchenbericht wurde für alle Patentansprüche erstellt.

| Recherchenort | Abschlußdatum der Recherche | Prüfer |
|---|---|---|
| WIEN | 26-08-1988 | SLAMA |